# EUROPEAN PATENT APPLICATION

(11) **EP 4 797 914 A1**
(43) Date of publication of application: **26.08.2026**
(21) Application number: 25196792.3
(22) Date of filing: 19.08.2025
(51) Int. Cl.: H10F 71/00, H10F 77/30

(54) **SOLAR CELL, PREPARATION METHOD THEREOF, AND PHOTOVOLTAIC MODULE**

(30) Priority: 20.02.2025 CN 202510185472
(71) Applicant: Tongwei Solar (Meishan) Co., Ltd., Meishan, Sichuan 620041 (CN)
(72) Inventor: HUANG, Zhi, Meishan, Sichuan, 620041 (CN); SHI, Xinxin, Meishan, Sichuan, 620041 (CN)
(74) Representative: Berggren Oy

(57) **Abstract**

The present application relates to a solar cell, a preparation method thereof, and a photovoltaic module. The solar cell includes a silicon substrate, and an emitter, a first silicon oxide layer, and an aluminum oxide layer are sequentially stacked on a light-receiving surface of the silicon substrate. The thickness of the first silicon oxide layer is in a range from 0.2 nm to 1.2 nm.

## Description

### TECHNICAL FIELD

The present application relates to the technical field of solar cells, in particular to a solar cell, a preparation method thereof, and a photovoltaic module.

### BACKGROUND

As the core component of photovoltaic modules, solar cells have a significant impact on the efficiency of photovoltaic modules. However, under the impact of ultraviolet (UV) exposure, the photoelectric conversion efficiency of solar cells may decline too soon, leading to noticeable power loss in photovoltaic modules. This phenomenon poses a serious challenge to the long-term stable operation of photovoltaic modules, significantly affecting the service life and operational performance of photovoltaic modules.

### SUMMARY

In order to mitigate the impact of UV exposure on the solar cell, embodiments of the present application provide a solar cell, a preparation method thereof, and a photovoltaic module.

A solar cell includes a silicon substrate having a light-receiving surface, an emitter, a first silicon oxide layer, an aluminum oxide layer, and a first anti-reflection layer that are sequentially stacked on the light-receiving surface. A thickness of the first silicon oxide layer is in a range from 0.2 nm to 1.2 nm.

In the embodiments of the present application, an interface state density of the first silicon oxide layer is in a range from 10¹¹ cm⁻²eV⁻¹ to 10¹² cm⁻²eV⁻¹.

In the embodiments of the present application, the thickness of the first silicon oxide layer is in a range from 0.3 nm to 0.8 nm.

In the embodiments of the present application, the silicon substrate is N-type, and the emitter is P-type.

In the embodiments of the present application, a thickness of the aluminum oxide layer is in a range from 3 nm to 8 nm.

In the embodiments of the present application, the first anti-reflection layer includes one of a first silicon nitride layer, a first silicon oxynitride layer, a second silicon oxide layer, or any combination thereof.

In the embodiments of the present application, the solar cell further includes a dielectric layer, a doped polysilicon layer, and a second anti-reflection layer that are sequentially stacked on a back surface of the silicon substrate.

In the embodiments of the present application, the second anti-reflection layer includes one of a second silicon nitride layer, a second silicon oxynitride layer, a third silicon oxide layer, or any combination thereof.

In the embodiments of the present application, the solar cell further includes a first electrode provided on the light-receiving surface of the silicon substrate, wherein the first electrode is in ohmic contact with the emitter; the solar cell further includes a second electrode provided on the back surface of the silicon substrate, and the second electrode is in ohmic contact with the doped polysilicon layer.

A method for preparing a solar cell includes the following steps:
providing a silicon substrate with an emitter on a light-receiving surface thereof;
forming an aluminum oxide layer on a surface of the emitter;
performing an indirect oxidation treatment to indirectly grow a first silicon oxide layer on the surface of the emitter.

In the embodiments of the present application, the indirect oxidation treatment includes treating the aluminum oxide layer through ionizing an oxygen source and/or annealing the aluminum oxide layer.

In the embodiments of the present application, the oxygen source includes CO₂, N₂O, H₂O, O₂, O₃ or any combination thereof; and/or
a process for the ionizing includes plasma-enhanced chemical vapor deposition (PECVD) or low-pressure chemical vapor deposition (LPCVD); and/or
a temperature for the annealing is in a range from 400 °C to 600 °C.

In the embodiments of the present application, the indirect oxidation treatment is the annealing, and O₂ or O₃ is introduced to form the first silicon oxide layer during the annealing.

In the embodiments of the present application, ionizing the oxygen source refers to ionizing N₂O.

In the embodiments of the present application, the indirect oxidation treatment is the annealing, and ionizing N₂O is conducted during the annealing.

In the embodiments of the present application, treating the aluminum oxide layer through ionizing N₂O is conducted under conditions as follows:
an ionizing time lasts for 10 seconds to 120 seconds, a flow rate of N₂O is in a range from 5,000 standard cubic centimeter per minute (sccm) to 20,000 sccm, an ionizing temperature is in a range from 450 °C to 470 °C, radio frequency (RF) power is in a range from 6,000 W to 12,000 W, and RF power source is turned on for 20 milliseconds (ms) to 50 milliseconds.

A photovoltaic module includes the solar cell as described in the first aspect or the solar cell prepared by the method as described in the second aspect.

In the embodiments of the present application, a first silicon oxide layer with a specific thickness in a range from 0.2 nm to 1.2 nm is introduced between the emitter and the aluminum oxide layer. The first silicon oxide layer can effectively reduce the defect state density at the interface between the emitter and the aluminum oxide layer while improving the anti-ultraviolet degradation performance of the photovoltaic module.

First, the first silicon oxide layer with the specific thickness can be tightly bond with the dangling bonds on the emitter surface by oxygen atoms to form a structurally stable and dense Si-O bond network. Such a structure can passivate the dangling bonds on the emitter surface while effectively reducing the number of hydrogen atoms escaping from Si-H bonds, thereby suppressing hydrogen atom migration, hydrogen atom accumulation, and hydrogen cluster formation that are induced by ultraviolet exposure and reducing carrier recombination. Consequently, the performance degradation of the solar cell under UV exposure can be mitigated. Second, the first silicon oxide layer provides an effective transition buffer between the emitter and the aluminum oxide layer, significantly alleviating lattice distortion at the interface, reducing the density of dangling bonds at the interface, and reducing carrier recombination.

Furthermore, in the present application, the thickness of the first silicon oxide layer plays a crucial role in the stability of the solar cell under UV exposure. The anti-UV stability of the solar cell exhibits a trend of first increasing and then decreasing as the thickness of the first silicon oxide layer increases. When the thickness of the first silicon oxide layer is less than 0.2 nm, the first silicon oxide layer exhibits a limited interfacial passivation effect on the emitter, and the interface state density remains relatively high. Consequently, the anti-UV stability of the solar cell cannot be improved significantly. However, when the thickness of the first silicon oxide layer is in a range from 0.2 nm to 0.8 nm, the interfacial passivation effect on the emitter reaches a superior range, and the interface state density decreases. Consequently, the anti-UV stability of the solar cell can be significantly improved accordingly. Nevertheless, once the thickness of the first silicon oxide layer exceeds 1.2 nm, experimental results show that anti-UV stability of the solar cell even deteriorates further.

### BRIEF DESCRIPTION OF THE DRAWINGS

In order to illustrate the technical solutions in the embodiments of the present application more clearly, the drawings used in the embodiments will be described briefly. Apparently, the following described drawings are merely for some embodiments of the present application, and other drawings can be derived by those of ordinary skill in the art without any creative effort.
FIG. 1 is a schematic structural view of a solar cell according to a first embodiment of the present application.
FIG. 2 is a schematic structural view of a solar cell according to a second embodiment of the present application.
FIG. 3 is a schematic structural view of a solar cell according to a third embodiment of the present application.

Reference signs:

1: silicon substrate; 11: emitter; 111: P-type emitter; 2: first silicon oxide layer; 3: aluminum oxide layer; 4: first anti-reflection layer; 41: first silicon nitride layer; 411: first silicon nitride sublayer; 412: second silicon nitride sublayer; 413: third silicon nitride sublayer; 42: first silicon oxynitride layer; 43: second silicon oxide layer; 51: dielectric layer; 511: fourth silicon oxide layer; 52: doped polysilicon layer; 6: second anti-reflection layer; 61: second silicon nitride layer; 71: first electrode; 72: second electrode.

### DETAILED DESCRIPTION

The technical solutions of the embodiments of the present application will be described more clearly and comprehensively below in conjunction with the accompanying drawings for the embodiments of the present application. Apparently, the embodiments described herein are only part of, not all of the embodiments of the present application. Base on the embodiments of the present application, other embodiments obtained by those of ordinary skill in the art without creative efforts shall fall within the protection scope of the present application.

In the present application, the orientation or position relationships indicated by the terms "upper", "lower", "left", "right", "front", "back", "top", "bottom", "inner", "outer", "central", "vertical", "horizontal", "transverse", "longitudinal", and the like are based on the orientation or position relationships shown in the accompanying drawings and are intended to describe the present application better, rather than defining that the apparatus, element or component referred to must have a particular orientation or be constructed and operated in a particular orientation.

Furthermore, in addition to indicating orientation or positional relationships, the aforementioned terms can also be used to express other meanings. For example, the term "upper" may in some cases be used to denote a certain dependency or connection relationship. The specific meanings of these terms in the present application can be understood based on specific circumstances by those of ordinary skills in the art.

Moreover, the terms "install", "arrange", "provided with", "connect to", and "connect with" should be interpreted in a broad sense. For example, they may refer to a fixed connection, a detachable connection, or an integral connection, may refer to a mechanical connection or an electrical connection, and may refer to a direct connection, an indirect connection via an intermediate medium, an internal communication between two devices, elements, or components. The specific meanings of these terms in the present application can be understood based on specific circumstances by those of ordinary skills in the art.

Additionally, the terms "first", "second", etc., are mainly used to distinguish different devices, elements, or components, specific types and structures of which may be the same or different, and the terms are not intended to indicate or imply the relative importance or quantity of the indicated devices, elements, or components. Unless otherwise specified, "a plurality of" means two or more.

Upon exposure to ultraviolet with a wavelength range from 300 nm to 400 nm, the photoelectric conversion efficiency of the solar cell easily tends to degrade. Specifically, ultraviolet light can break silicon-hydrogen (Si-H) bonds in the passivation layer and/or anti-reflection layer on the silicon substrate surface. After hydrogen atoms escape from the silicon-hydrogen bonds, the passivation effect of the passivation layer and/or anti-reflection layer on the silicon substrate surface weakens, enhancing carrier recombination and thus reducing the photoelectric conversion efficiency of the solar cell, which is mainly manifested as a reduction in open-circuit voltage. Therefore, optimizing the design and manufacturing process of solar cells to mitigate UV-induced performance degradation has become a key research focus.

The technical solutions of the present application will be further described below in conjunction with embodiments and accompanying drawings.

In a first aspect, an embodiment of the present application provides a solar cell.

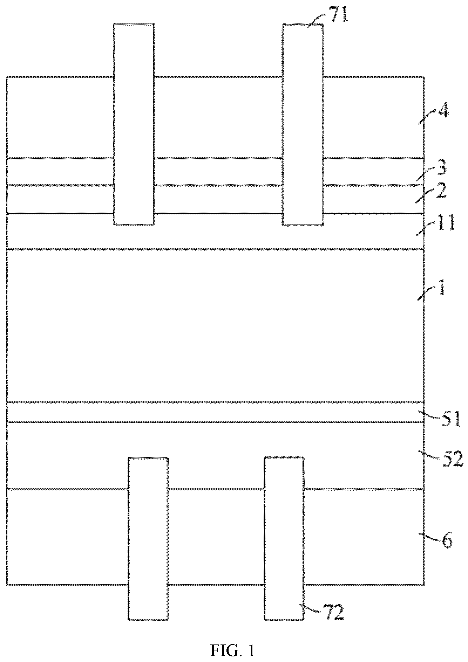

Referring to FIG. 1, a solar cell according to a first embodiment includes a silicon substrate 1 having a light-receiving surface. The solar cell further includes an emitter 11, a first silicon oxide layer 2, an aluminum oxide layer 3, and a first anti-reflection layer 4 that are sequentially stacked on the light-receiving surface of the silicon substrate 1.

According to one embodiment, a thickness of the first silicon oxide layer 2 is in a range from 0.2 nm to 1.2 nm.

The first silicon oxide layer 2 with a specific thickness in a range from 0.2 nm to 1.2 nm is introduced between the emitter 11 and the aluminum oxide layer 3. The first silicon oxide layer 2 is not directly prepared onto the surface of the emitter 11 from a silicon oxide material. Instead, it is formed by oxygen atoms from the aluminum oxide layer 3 and/or high-energy-state oxygen atoms, e.g., ionized oxygen atoms. These oxygen atoms migrate through the aluminum oxide layer 3 and thus indirectly act on the surface of the emitter, thereby forming the first silicon oxide layer 2 at the interface between the emitter 11 and the aluminum oxide layer 3.

The silicon oxide in the first silicon oxide layer 2 is formed by transferring oxygen atoms from the aluminum oxide layer 3 to the surface of the emitter 11 or by acting high-energy-state oxygen atoms, e.g., ionized oxygen atoms on the aluminum oxide layer 3 to provide an oxygen source for the formation of the first silicon oxide layer 2. Therefore, when preparing the silicon oxide layer under ambient condition or other non-oxygen-containing media, the aluminum oxide layer effectively isolates impurities from the air or in the non-oxygen-containing media, reducing the likelihood of impurity doping into the silicon oxide material, thereby providing an oxygen source with relatively high pure and fewer impurity atoms for the formation of the first silicon oxide layer 2. As a result, the prepared first silicon oxide layer 2 exhibits a relatively low interface state density and superior interfacial passivation effects.

It should be noted that conventional methods for preparing silicon oxide layers include hydrogen peroxide oxidation, ozone oxidation, wet oxygen oxidation, dry oxygen oxidation, etc. These methods all involve directly preparing a silicon oxide layer on the emitter surface and then depositing the aluminum oxide layer. The oxygen atom source is provided by hydrogen peroxide, an oxygen atmosphere, H₂O, or ozone. The substances providing the oxygen atom source cannot achieve 100% purity, and when preparing silicon oxide using a high-temperature furnace, the high-temperature furnace environment cannot achieve an absolute vacuum condition. Considering that the silicon oxide layer at the interface between the emitter 11 and the aluminum oxide layer 3 is extremely thin, not exceeding 2 nm, making the silicon oxide layer extremely sensitive to impurities. Therefore, even the furnace environment with very low vacuum level cannot provide an oxygen atom source with relatively purity, so that the silicon oxide layer conventionally prepared on the emitter 11 surface is prone to impurity incorporation, which adversely affects the long-term stability of the emitter interface and is unfavorable for the improvement of the solar cell's anti-UV degradation performance. In contrast, the indirect oxidation treatment method adopted in the present application can effectively reduce the adverse effects of insufficient purity of the oxygen atom source and impurities in a preparing environment atmosphere, significantly minimizing impurity introduced into the silicon oxide layer. Therefore, the silicon oxide layer obtained by the indirect oxidation treatment has fewer impurities, higher quality, and is more conducive to enhancing the stability of solar cells under UV exposure.

The interface state density of the first silicon oxide layer is in a range from 10¹¹ cm⁻²eV⁻¹ to 10¹² cm⁻²eV⁻¹, which can effectively reduce carrier recombination caused by lattice mismatch at the interface between the emitter 11 and the aluminum oxide layer 3, thereby suppressing the performance degradation of the solar cell under UV exposure.

Specifically, first, the first silicon oxide layer with the specific thickness can be tightly bond with the silicon dangling bonds on the emitter surface by oxygen atoms to form a stable and dense Si-O bond network with a relatively low interface state density. Such a structure can effectively passivate the silicon dangling bonds on the emitter surface, so that the emitter surface can possess a relatively low defect state density, thereby providing a superior interfacial passivation effect and a relatively high open-circuit voltage for the solar cell. Additionally, the front surface of the solar cell in the present application has a structurally dense and high-bond-energy aluminum oxide layer 3, which can effectively block UV photons from damaging the Si-O bonds in the first silicon oxide layer 2. Moreover, since the aluminum oxide layer 3 prepared by atomic layer deposition (ALD) contains hydrogen atoms, these hydrogen atoms can migrate from the aluminum oxide layer 3 into the first silicon oxide layer 2, further enhancing the interfacial passivation effect of the first silicon oxide layer 2. As a result, the degradation in the solar cell's electrical performance under UV exposure can be mitigated. That is, the power loss of photovoltaic modules under UV exposure can be reduced.

In the present application, the thickness of the first silicon oxide layer 2 plays a role in the stability of the solar cell under UV exposure. The anti-UV stability of the solar cell exhibits a trend of first increasing and then decreasing as the thickness of the first silicon oxide layer changes. When the thickness of the first silicon oxide layer 2 is less than 0.2 nm, the first silicon oxide layer 2 exhibits a limited interfacial passivation effect on the emitter, and the interface state density remains relatively high. Consequently, the interfacial passivation effect of the solar cell is inferior, which is unfavorable for preparing a solar cell with high efficiency. However, when the thickness of the first silicon oxide layer 2 is in a range from 0.2 nm to 0.8 nm, the interfacial passivation effect on the emitter reaches a superior range, and the interface state density decreases. Consequently, the anti-UV stability of the solar cell can be significantly improved accordingly. Nevertheless, once the thickness of the first silicon oxide layer exceeds 1.2 nm, it has been found by the inventors that anti-UV stability of the solar cell even deteriorates further.

Exemplary, the thickness of the first silicon oxide layer 2 can be 0.2 nm, 0.3 nm, 0.5 nm, 0.6 nm, 0.8 nm, 1.0 nm, or 1.2 nm.

In one embodiment, the thickness of the first silicon oxide layer 2 is in a range from 0.3 nm to 0.8 nm.

By further adjusting the thickness of the first silicon oxide layer 2 within the above range, not only can the first silicon oxide layer 2 provide a superior interfacial passivation effect, but the barrier to hole carrier transport caused by the field effect of the positive first silicon oxide layer 2 can also be more effectively reduced. Meanwhile, it facilitates the tunneling of photogenerated carriers. As a result, the combination of the first silicon oxide layer 2 and the aluminum oxide layer 3 yields an excellent interface passivation effect on the emitter 11 surface, further enhancing the anti-UV degradation performance of the solar cell.

In some embodiments, the silicon substrate 1 is N-type, and the emitter 11 is P-type.

The P-type emitter 111 can provide hole carriers during solar cell operation. The aluminum oxide layer 3, as a negatively charged layer, provides a favorable field effect for transporting the hole carriers, promoting the drift of hole carriers. This mechanism enhances the efficient migration of hole carriers. Conversely, the first silicon oxide layer 2, being positively charged, can repel hole carriers, forming a hindering field effect for the drift of hole carriers. By controlling the thickness of the first silicon oxide layer 2 between the P-type emitter 111 and the aluminum oxide layer 3 within a specific range, the hindering field-effect of the first silicon oxide layer 2 on hole carrier tunneling and drift can be effectively reduced, facilitating the migration of hole carriers. Meanwhile, the first silicon oxide layer 2 can also provide excellent interfacial passivation effective on the interface between the P-type emitter 111 and the aluminum oxide layer 3. Additionally, N-type silicon substrate-based solar cells exhibit high conversion efficiency and long-term reliability, making the solutions of the present application particularly suitable for designs incorporating a P-type emitter 111.

In some embodiments, a thickness of the aluminum oxide layer 3 is in a range from 3 nm to 8 nm. The aluminum oxide layer 3 with the above thickness provides an excellent passivation effect on the solar cell while facilitating the migration of oxygen atoms through the aluminum oxide layer 3 to the emitter 11 surface, thereby forming the first silicon oxide layer 2 with a specific thickness.

Exemplary, the thickness of the aluminum oxide layer 3 can be 3 nm, 5 nm, or 8 nm.

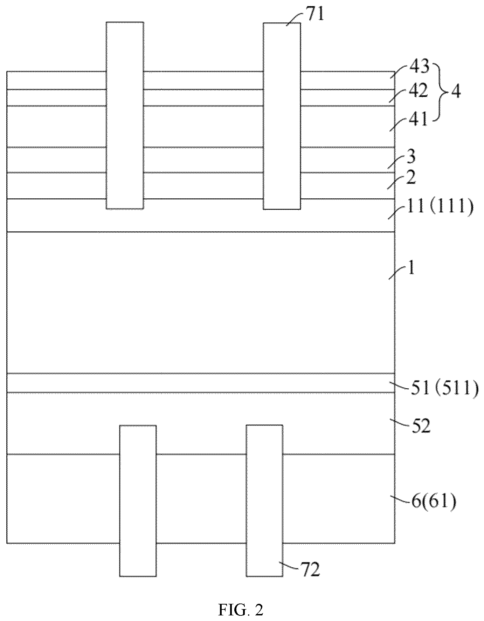

Referring to FIG. 2, in a second embodiment, a first anti-reflection layer 4 is provided on a side of the aluminum oxide layer 3 away from the silicon substrate 1. The first anti-reflection layer 4 includes a first silicon nitride layer 41, a first silicon oxynitride layer 42, a second silicon oxide layer 43, or any combination thereof.

The first silicon nitride layer 41 and the first silicon oxynitride layer 42 are hydrogen-rich films. Hydrogen atoms bond with Si atoms in the films to form Si-H bonds, which effectively optimizes interface contact performance, further reducing the interface state density of the solar cell, lowering carrier recombination loss, and improving the open-circuit voltage and the electrical performance of the solar cell.

When hydrogen atoms in the first silicon nitride layer 41 and/or the first silicon oxynitride layer 42 that are on the front surface of the solar cell escape out under UV exposure, the structurally dense and high-bond-energy aluminum oxide layer 3 can effectively block the escaped hydrogen atoms, thereby slowing down the significant decrease in hydrogen atom density in the first silicon nitride layer 41 and/or the first silicon oxynitride layer 42 under UV exposure.

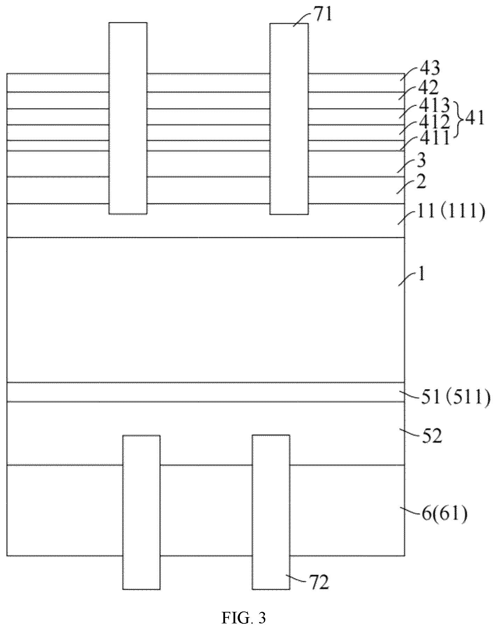

Referring to FIG. 3, in a third embodiment, the first silicon nitride layer 41 includes a first silicon nitride sublayer 411, a second silicon nitride sublayer 412, and a third silicon nitride sublayer 413. By adjusting the ratio of silicon atoms to nitrogen atoms in the first silicon nitride sublayer 411, the second silicon nitride sublayer 412, and the third silicon nitride sublayer 413, the first silicon nitride layer 41 can achieve an excellent anti-reflection effect.

The second silicon oxide layer 43 can also serve as an effective anti-reflection material, which not only ensures good light transmittance but also can form a multilayer anti-reflection structure when combined with the first silicon nitride layer 41 or the first silicon oxynitride layer 42, thereby further optimizing spectral response and broadening the light absorption range.

Referring to FIG. 2, in some embodiments, the first anti-reflection layer 4 includes the first silicon nitride layer 41, the first silicon oxynitride layer 42, and the second silicon oxide layer 43 that are sequentially stacked.

Referring back to FIG. 1, in some embodiments, a dielectric layer 51, a doped polysilicon layer 52, and a second anti-reflection layer 6 are sequentially stacked on a back surface of the silicon substrate.

The second anti-reflection layer 6 includes a second silicon nitride layer 61, a second silicon oxynitride layer, a third silicon oxide layer, or any combination thereof.

Further, referring to FIG. 2, in some embodiments, the second anti-reflection layer 6 is the second silicon nitride layer 61.

The material of the dielectric layer 51 can include various dielectric materials, such as at least one of silicon oxide, magnesium fluoride, amorphous silicon, polysilicon, silicon carbide, silicon nitride, silicon oxynitride, aluminum oxide, and titanium oxide. Specifically, the dielectric layer 51 can be composed of a fourth silicon oxide layer 511 containing silicon oxide. The fourth silicon oxide layer 511 has excellent passivation performance, which can minimize recombination losses of minority carriers at the surface of the emitter 11, and is a thin film with outstanding durability for subsequent high-temperature processes.

In order to improve the interfacial passivation effect of the silicon substrate 1, the thickness of the dielectric layer 51 can range from 0.5 nm to 3 nm. For example, the thickness of the dielectric layer 51 can be 0.5 nm, 0.8 nm, 1 nm, 1.5 nm, 2 nm, 3 nm, etc. However, the present application is not limited hereto, and the thickness of the dielectric layer 51 can also be other values.

The conductivity type of the doped polysilicon layer 52 is opposite to that of the emitter 11 to achieve effective separation and collection of carriers. Specifically, when the conductivity type of the emitter 11 is P-type (i.e., mainly doped with electron-accepting elements such as boron), the conductivity type of the doped polysilicon layer 52 is correspondingly configured to be N-type (i.e., mainly doped with electron-donating elements). In this case, the conductive element doped in the doped polysilicon layer 52 is an N-type element, typically phosphorus, which can introduce additional free electrons into the silicon lattice of the doped polysilicon layer 52, thereby enhancing the electron conductivity of the doped polysilicon layer 52 and improving the transport capability of electron carriers.

Referring back to FIG. 1, in some embodiments, a first electrode 71 is provided on the light-receiving surface of the silicon substrate 1. The first electrode 71 forms ohmic contact with the emitter 11. A second electrode 72 is provided on the back surface of the silicon substrate 1. The second electrode 72 forms ohmic contact with the doped polysilicon layer 52.

In a second aspect, an embodiment of the present application provides a method for preparing a solar cell.

A method for preparing a solar cell includes the following steps:
providing a silicon substrate 1 with an emitter 11 on a light-receiving surface thereof;
forming an aluminum oxide layer 3 on a surface of the emitter 11; and
performing an indirect oxidation treatment to indirectly grow a first silicon oxide layer 2 on the surface of the emitter 11.

It has been found by the inventors that in the preparation process of the solar cell, a stable, dense Si-O bond network with low interface state density can be prepared by first forming the aluminum oxide layer 3, and then performing the indirect oxidation treatment such that an oxygen source can pass through the aluminum oxide layer 3 to the surface of the emitter 11 to indirectly grow the first silicon oxide layer 2, which can more effectively improve the interfacial passivation effect between the aluminum oxide layer 3 and the emitter 11, thereby allowing the solar cell to achieve a relatively high open-circuit voltage and improved photoelectric conversion efficiency. Additionally, the first silicon oxide layer 2 grown through the indirect oxidation treatment has a relatively dense structure. When hydrogen atoms escape from the silicon nitride and/or silicon oxynitride passivation layers on the front surface of the solar cell under UV exposure, the structurally dense first silicon oxide layer 2 can effectively block the diffusion of hydrogen atoms, enhancing the anti-UV degradation performance of the solar cell.

When the preparation order of the aluminum oxide layer 3 and the first silicon oxide layer 2 is reversed to form the silicon oxide layer by a direct oxidation treatment, i.e., the silicon oxide layer is formed first followed by forming the aluminum oxide layer 3, the resulting silicon oxide layer is of poor quality with high interface state density. The possible mechanism analyzed by the inventors may be as follows: When the silicon oxide layer is prepared by a direct oxidation treatment, for example, the silicon oxide layer is prepared at the interface between emitter 11 and aluminum oxide layer 3 by hydrogen peroxide oxidation, ozone oxidation, wet oxygen oxidation, dry oxygen oxidation, etc, the oxygen atom source is provided by hydrogen peroxide, an oxygen atmosphere with low purity, H₂O, or ozone. The substances providing the oxygen atom source for the direct oxidation treatment cannot achieve 100% purity, and when preparing silicon oxide using a high-temperature furnace, the high-temperature furnace environment cannot achieve an absolute vacuum condition. Considering that the silicon oxide layer at the interface between the emitter 11 and the aluminum oxide layer 3 is extremely thin, not exceeding 2 nm. Therefore, even the furnace environment with very low vacuum level cannot provide an oxygen atom source with relatively purity. As a result, when the silicon oxide layer is prepared at the interface between emitter 11 and aluminum oxide layer 3 by the direct oxidation treatment, the stability of the solar cell under UV exposure cannot be enhanced significantly or even becomes worse.

In some embodiments, the indirect oxidation treatment includes treating through ionizing an oxygen source and/or annealing at 400 °C to 600 °C, and the oxygen source includes one of CO₂, N₂O, H₂O, O₂, O₃ or any combination thereof. As for treating through ionizing an oxygen source, the ionizing process includes plasma-enhanced chemical vapor deposition (PECVD) or low-pressure chemical vapor deposition (LPCVD).

After the preparation of the aluminum oxide layer 3, through ionizing the oxygen source, the ionized oxygen atoms can pass through the aluminum oxide layer 3 to reach the surface of the emitter 11 and form a first silicon oxide layer 2 with a specific thickness on the surface of the emitter 11. Since the aluminum oxide layer 3 contains H atoms, when the surface of the aluminum oxide layer 3 is treated with ionized oxygen atoms, the H atoms can also migrate into the first silicon oxide layer 2 during the high-energy treatment with the ionized oxygen atoms and/or annealing process at 400 °C to 600 °C, further enhancing the surface passivation effect of the emitter on the front surface of the solar cell, thereby improving the open-circuit voltage and photoelectric conversion efficiency.

In some embodiments, the indirect oxidation treatment includes annealing the aluminum oxide layer 3 at 400 °C 600 °C. The high-temperature treatment causes oxygen atoms in the aluminum oxide layer 3 to migrate into the first silicon oxide layer 2, further enhancing the surface passivation effect of the emitter on the front surface of the solar cell, which is conducive to improving the open-circuit voltage and photoelectric conversion efficiency.

In some embodiments, the indirect oxidation treatment includes ionizing N₂O, ionizing time period lasts for 10 seconds to 120 seconds, a flow rate of N₂O is in a range from 5000 sccm to 20000 sccm, an ionizing temperature is in a range from 450 °C to 470 °C, radio frequency (RF) power is in a range from 6000 W to 12000 W, RF power source is turned on for 20 milliseconds to 50 milliseconds, and the temperature is maintained for 5 minutes to 60 minutes. The oxygen atoms in a high-energy (i.e., an ionized) state can promote the formation of more structurally stable Si-O bonds with silicon atoms on the emitter surface.

After the preparation of the first silicon oxide layer 2 is completed, the first anti-reflection layer 4 is prepared. The following provides a more detailed explanation of the preparation of the first anti-reflection layer 4. In some embodiments, a first silicon nitride layer 41 is prepared on the side of the aluminum oxide layer 3 away from the silicon substrate 1 using PECVD, with a deposition temperature of 450 °C to 470 °C. The first silicon nitride layer 41 consists of a first silicon nitride sublayer 411, a second silicon nitride sublayer 412, and a third silicon nitride sublayer 413 that are stacked sequentially on the side of the aluminum oxide layer 3 away from the first silicon oxide layer 2. The first silicon nitride sublayer 411, the second silicon nitride sublayer 412, and the third silicon nitride sublayer 413 each can be prepared by adjusting PECVD parameters including deposition time, SiH₄ flow rate, NH₃ flow rate, deposition pressure, RF power, and the duration of RF power source being on or off to form the corresponding silicon nitride layers. It should be noted that the first silicon nitride layer 41 can be a single-layer or a multi-layer. Different silicon nitride layers are distinguished based on variations in the above PECVD deposition conditions. For example, when any one of PECVD parameters such as deposition time, SiH₄ flow rate, NH₃ flow rate, deposition pressure, RF power, or the duration of RF power source being on or off differs, the resulting silicon nitride layers are considered to have different structures in the present application.

In some embodiments, a first silicon oxynitride layer 42 is prepared on the side of the first silicon nitride layer 41 away from the N-type monocrystalline silicon wafer using PECVD. The first silicon oxynitride layer 42 can be prepared by adjusting PECVD parameters including deposition time, SiH₄ flow rate, N₂O flow rate, deposition pressure, RF power, and the duration of the RF power source being on or off. It should be noted that the first silicon oxynitride layer 42 can be a single-layer or a multi-layer. Different silicon oxynitride layers are distinguished based on variations in the above PECVD deposition conditions. For example, when any one of PECVD parameters such as deposition time, SiH₄ flow rate, N₂O flow rate, deposition pressure, RF power, or the duration of the RF power source being on or off differs, the resulting silicon oxynitride layers are considered to have different structures in the present application.

In some embodiments, a second silicon oxide layer 43 is prepared on the side of the first silicon oxynitride layer 42 away from the N-type monocrystalline silicon wafer. The second silicon oxide layer 43 can be prepared by adjusting PECVD parameters including deposition time, SiH₄ flow rate, N₂O flow rate, deposition pressure, RF power, and the duration of the RF power source being on or off to form the corresponding second silicon oxide layer. It should be noted that the second silicon oxide layer 43 can be a single-layer or a multi-layer. Different silicon oxide layers are distinguished based on variations in the above PECVD deposition conditions. For example, when any one of PECVD parameters such as deposition time, SiH₄ flow rate, N₂O flow rate, deposition pressure, RF power, or the duration of the RF power source being on or off differs, the resulting silicon oxynitride layers are considered to have different structures in the present application.

In a third aspect, an embodiment of the present application provides a photovoltaic module.

A photovoltaic module includes the solar cell as described in the first aspect or the solar cell prepared by the method as described in the second aspect.

The technical solutions of the present application will be further described in detail in conjunction with more specific embodiments and accompanying drawings.

### Example 1

This example of the present application provides a solar cell, with a preparation method including the following steps:

An N-type monocrystalline silicon wafer was provided, a P-type boron emitter was formed on the light-receiving surface of the N-type monocrystalline silicon wafer through boron diffusion, and a borosilicate glass (BSG) layer was removed through wet process.

A dielectric layer and a phosphorus-doped amorphous silicon layer were sequentially prepared on the back surface of the N-type monocrystalline silicon wafer by the PECVD method, followed by annealing at 950 °C for 90 minutes to transform the phosphorus-doped amorphous silicon layer to a phosphorus-doped polysilicon layer.

A natural silicon oxide layer on the light-receiving surface of the N-type monocrystalline silicon wafer was removed through the RCA wet process.

An aluminum oxide layer was prepared on the surface of the P-type boron emitter using the ALD method.

N₂O was ionized for 30 seconds at a temperature of 450 °C to 550°C by the PECVD method, where an N₂O flow rate was 10,000 sccm, an RF power was 8,000 W, and RF power source was turned on for 35 ms. The treatment was conducted for 5 minutes to 60 minutes at the temperature of 450 °C 550 °C to grow a first silicon oxide layer on the surface of the P-type boron emitter adjacent to the aluminum oxide layer through such an indirect oxidation treatment.

A first silicon nitride layer was prepared by the PECVD method at a deposition temperature of 450 °C to 470 °C. The first silicon nitride layer was composed of a first silicon nitride sublayer, a second silicon nitride sublayer, and a third silicon nitride sublayer that were sequentially stacked on the side of the aluminum oxide layer away from the first silicon oxide layer. The first silicon nitride sublayer was deposited for 75 seconds under an SiH₄ flow rate of 2,000 sccm and an NH₃ flow rate of 6,500 sccm at a pressure of 1,600 millitorr (mTorr) with an RF power of 13,500 W. The second silicon nitride sublayer was deposited for 125 seconds under a SiH₄ flow rate of 1,100 sccm and an NH₃ flow rate of 8,000 sccm at a pressure of 1,600 mTorr with an RF power of 14,000 W. The third silicon nitride sublayer was deposited for 160 seconds under a SiH₄ flow rate of 1,000 sccm and an NH₃ flow rate of 10,000 sccm at a pressure of 1,600 mTorr with an RF power of 14,000 W. The RF power source was turned on for 35 ms and off for 550 ms.

A first silicon oxynitride layer was prepared on the side of the first silicon nitride layer away from the N-type monocrystalline silicon wafer by the PECVD method, where the deposition time lasted for 300 seconds, the SiH₄ flow rate was 900 sccm, the NH₃ flow rate was 3,500 sccm, the N₂O flow rate was 7,500 sccm, the pressure was 1,200 mTorr, the RF power was 13,500 W, and the RF power source was turned on for 35 ms and off for 900 ms.

A second silicon oxide layer was prepared on the side of the first silicon oxynitride layer away from the N-type monocrystalline silicon wafer by the PECVD method, where a deposition time lasted for 120 seconds, the SiH₄ flow rate was 750 sccm, the N₂O flow rate was 9,500 sccm, the pressure was 1,150 mTorr, the RF power was 13,500 W, and the RF power source was turned on for 35 ms and off for 900 ms.

A second silicon nitride layer was prepared on the side of the phosphorus-doped polysilicon layer away from the N-type monocrystalline silicon wafer by the PECVD method.

A first electrode was prepared on the light-receiving surface, and the first electrode formed an ohmic contact with the P-type boron emitter. A second electrode was prepared on the back surface, and the second electrode formed an ohmic contact with the phosphorus-doped polysilicon layer.

### Example 2

This example of the present application provided a solar cell, which differed from Example 1 in that: the thickness of the first silicon oxide layer was different. Specifically, in the step of ionizing N₂O, the ionizing time lasted for 60 seconds, while the rest remained consistent with Example 1.

### Example 3

This example of the present application provided a solar cell, which differed from Example 1 in that: the thickness of the first silicon oxide layer was different. Specifically, in the step of ionizing N₂O, the ionizing time lasted for 120 seconds, while the rest remained consistent with Example 1.

### Example 4

This example of the present application provided a solar cell, which differed from Example 1 in that: the thickness of the first silicon oxide layer was different. Specifically, in the step of ionizing N₂O, the ionizing time lasted for 180 seconds, while the rest remained consistent with Example 1.

### Comparative Example

This comparative example provided a solar cell, which differed from Example 3 in that: after the preparation of the aluminum oxide layer, the step of ionizing N₂O by the PECVD method was omitted. That is, no first silicon oxide layer was prepared between the aluminum oxide layer and the P-type boron emitter, and a silicon nitride layer was directly prepared instead. The rest remained consistent with Example 3.

### Experiment 1

Thickness measurement of the first silicon oxide layer

The thickness of the first silicon oxide layer was measured using the energy-dispersive x-ray spectroscopy (EDS) elemental scanning function in the transmission electron microscopy (TEM) or the high-resolution transmission electron microscopy (HR-TEM). The interface boundary line with obvious color differences in the EDS scanning image was selected as the reference for measurement. The thickness test results of the first silicon oxide layers in Examples and Comparative Example are shown in Table 1.

### Experiment 2

### Battery efficiency degradation testing

### 2.1 Solar cell degradation performance testing

Solar cells prepared by the methods of the above Examples and Comparative Example were used as testing samples. The photoelectric conversion efficiency of the solar cell samples was measured before and after a UV aging treatment. The efficiency degradation difference after the UV aging treatment was calculated by subtracting the photoelectric conversion efficiency after UV aging from that before UV aging.

UV aging treatment: The solar cell samples were irradiated continuously for 60 kWh at 60±5°C with a wavelength range of 280 nm to 400 nm under an irradiation intensity of 200 W/m². After irradiation, the IV test of the solar cell samples were conducted again. The percentage difference in efficiency before and after irradiation was taken as the efficiency degradation difference of the solar cells.

### 2.2 Photovoltaic module degradation performance testing

Solar cells prepared by the methods of the above Examples and Comparative Example were encapsulated into photovoltaic module samples. The maximum power of these photovoltaic module samples was measured before and after a UV aging treatment. The power degradation difference after the UV aging treatment was calculated by subtracting the power after UV aging from that before UV aging.

UV aging treatment: The solar cells were encapsulated into double-glass photovoltaic modules. After encapsulation, the modules were stood for 24 hours before IV test. After that, the modules were placed in a UV irradiation chamber under the following testing conditions: 60±5°C, wavelength range of 280 nm to 400 nm, irradiation intensity of 200 W/m², and continuous stable irradiation for 60 kWh. After irradiation, the IV test were conducted again. The power difference before and after irradiation was taken as the power degradation difference of the photovoltaic modules.

The test results of the battery efficiency degradation test in Experiment 2 are recorded in Table 1. Due to potential differences in crystal structures across different regions of the silicon substrate surface, silicon atoms on the surfaces of the emitters across the different regions may exhibit varying reaction activities. Consequently, the thickness of the prepared first silicon oxide layer under an identical indirect oxidation treatment condition may fluctuate within a certain numerical range. In the present application, as for the thicknesses of the first silicon oxide layers in examples 1 to 4, in combination with the description of the thickness measurement of the first silicon oxide layer in Experiment 1, the thinnest measured section of the first silicon oxide layer is selected to define the thickness of the first silicon oxide in the present application. However, if the thickness of the first silicon oxide layer in a specific region of the tested cross-section is significantly lower than that in other regions, and this specific region accounts for more than 30% of the selected cross-section, such a region is considered as an abnormal test region and excluded from the thickness measurement selection region for the first silicon oxide layer.

**Table 1**

| | Thickness of the first silicon oxide layer / nm | Efficiency degradation difference of the solar cells | Power degradation difference of the photovoltaic modules |
|---|---|---|---|
| Example 1 | 0.2-0.4 | 1.20% | 1.20% |
| Example 2 | 0.6-0.8 | 0.50% | 0.80% |
| Example 3 | 0.8-1.2 | 1.00% | 1.10% |
| Example 4 | 1.4-1.6 | 2.70% | 2.21% |
| Comparative Example | Not tested | 2.20% | 1.50% |

As can be seen from Table 1:

First, when Comparative Example 1 uses the direct oxidation treatment method to form a silicon oxide layer between the emitter and the aluminum oxide layer, both the solar cell efficiency degradation difference and the photovoltaic module power degradation difference are greater than those in Examples 1 to 4, indicating that the first silicon oxide layer prepared between the emitter and the aluminum oxide layer by the indirect oxidation treatment method of the present application exhibits superior anti-UV degradation performance.

Second, compared with Examples 1 to 3, Example 4 shows relatively higher solar cell efficiency degradation difference and photovoltaic module power degradation difference before and after UV aging tests. This indicates that excessively long treatment time of the plasma from an oxygen source may damage the structure of the aluminum oxide layer and/or the first silicon oxide layer, or may exacerbate the breaking of hydrogen bonds in the aluminum oxide layer and/or the first silicon oxide layer, thereby causing the efficiency degradation and/or UV aging performance degradation of the solar cells. Therefore, when the thickness of the first silicon oxide layer ranges from 0.2 nm to 1.2 nm, it is conducive to mitigating the UV aging degradation performance of the solar cells.

Third, compared with other examples, Example 2 exhibits the lowest solar cell efficiency degradation difference and photovoltaic module power degradation difference before and after UV aging tests, demonstrating the excellent anti-UV degradation performance, indicating that the thickness of the first silicon oxide layer is preferably in a range from 0.6 nm to 0.8 nm.

## Claims

1. A solar cell, comprising:
a silicon substrate (1) having a light-receiving surface;
an emitter (11), a first silicon oxide layer (2), an aluminum oxide layer (3), and a first anti-reflection layer (4) that are sequentially stacked on the light-receiving surface;
wherein a thickness of the first silicon oxide layer (2) is in a range from 0.2 nm to 1.2 nm.

2. The solar cell according to claim 1, wherein an interface state density of the first silicon oxide layer (2) is in a range from 10¹¹ cm⁻²eV⁻¹ to 10¹² cm⁻²eV⁻¹.

3. The solar cell according to claim 1, wherein the thickness of the first silicon oxide layer (2) is in a range from 0.3 nm to 0.8 nm.

4. The solar cell according to claim 1, wherein the silicon substrate (1) is N-type, and the emitter (11) is P-type.

5. The solar cell according to claim 1, wherein a thickness of the aluminum oxide layer (3) is in a range from 3 nm to 8 nm; and/or
the first anti-reflection layer (4) comprises one of a first silicon nitride layer (41), a first silicon oxynitride layer (42), a second silicon oxide layer (43), or any combination thereof.

6. The solar cell according to claim 1 to 5, further comprising a dielectric layer (51), a doped polysilicon layer (52), and a second anti-reflection layer (6) that are sequentially stacked on a back surface of the silicon substrate (1);
wherein the second anti-reflection layer (6) comprises one of a second silicon nitride layer (61), a second silicon oxynitride layer, a third silicon oxide layer, or any combination thereof.

7. The solar cell according to claim 6, further comprising:
a first electrode (71) provided on the light-receiving surface of the silicon substrate (1);
wherein the first electrode (71) is in ohmic contact with the emitter (11); the solar cell further comprises a second electrode (72) provided on the back surface of the silicon substrate (1), and
the second electrode (72) is in ohmic contact with the doped polysilicon layer (52).

8. A method for preparing a solar cell, comprising:
providing a silicon substrate (1) with an emitter (11) on a light-receiving surface thereof;
forming an aluminum oxide layer (3) on a surface of the emitter (11); and
performing an indirect oxidation treatment to indirectly grow a first silicon oxide layer (2) on the surface of the emitter (11).

9. The method according to claim 8, wherein the indirect oxidation treatment comprises treating the aluminum oxide layer (3) through ionizing an oxygen source and/or annealing the aluminum oxide layer (3).

10. The method according to claim 9, wherein the oxygen source comprises one of CO₂, N₂O, H₂O, O₂, O₃ or any combination thereof; and/or
a process for the ionizing comprises plasma-enhanced chemical vapor deposition (PECVD) or low-pressure chemical vapor deposition (LPCVD); and/or
a temperature for the annealing is in a range from 400 °C to 600 °C.

11. The method according to claim 9 or 10, wherein O₂ or O₃ is introduced to form the first silicon oxide layer (2) during the annealing.

12. The method according to claim 11, wherein ionizing the oxygen source is to ionize N₂O.

13. The method according to claim 9, wherein the indirect oxidation treatment is annealing the aluminum oxide layer (3), and ionizing the N₂O is conducted during the annealing.

14. The method according to claim 12 or 13, wherein treating the aluminum oxide layer (3) through ionizing the N₂O is conducted under conditions as follows:
an ionizing time lasts for 10 seconds to 120 seconds;
a flow rate of N₂O is in a range from 5000 standard cubic centimeter per minute (sccm) to 20000 sccm;
an ionizing temperature is in a range from 450 °C to 470 °C;
radio frequency (RF) power is in a range from 6000 W to 12000 W; and
RF power source is turned on for 20 milliseconds to 50 milliseconds.

15. A photovoltaic module, comprising the solar cell according to any one of claims 1 to 7 or the solar cell prepared by the method according to any one of claims 8 to 14.
